# EUROPÄISCHE PATENTSCHRIFT

(11) **EP 2 936 667 B1**
(45) Veröffentlichungstag und Bekanntmachung des Hinweises auf die Patenterteilung: **03.08.2022**
(21) Anmeldenummer: 13807958.7
(22) Anmeldetag: 06.12.2013
(51) Int. Cl.: H02M 1/32, H02K 11/00, H02H 7/08, H02H 7/122, H02M 7/5395

(54) **VERFAHREN ZUM ÜBERWACHEN EINES HALBBRÜCKENZWEIGES IN EINER HALBBRÜCKE SOWIE STROMRICHTER MIT DIESER ÜBERWACHUNG**
METHOD OF MONITORING A HALF-BRIDGE BRANCH IN A HALF-BRIDGE, AND POWER CONVERTER COMPRISING SUCH MONITORING
PROCÉDÉ DE SURVEILLANCE D'UNE BRANCHE DANS UN DEMI-PONT ET CONVERTISSEUR DE PUISSANCE AVEC CETTE SURVEILLANCE

(30) Priorität: 20.12.2012 DE 102012223877
(43) Veröffentlichungstag der Anmeldung: 28.10.2015
(73) Patentinhaber: Robert Bosch GmbH, 70442 Stuttgart (DE)
(72) Erfinder: SCHULZE-ICKING-KONERT, Georg, 77830 Buehlertal (DE); JACOB, Matthias, 77836 Rheinmuenster (DE); FISCHER, Frank, 77815 Buehl (DE)
(86) Internationale Anmeldenummer: PCT/EP2013/075786
(87) Internationale Veröffentlichungsnummer: WO 2014/095422

(56) Entgegenhaltungen:
- US-A- 4 369 492
- US-A1- 2007 035 976
- US-A1- 2009 045 763

## Beschreibung

### Technisches Gebiet

Die Erfindung betrifft allgemein Fahrzeuge, insbesondere Fahrzeuge mit Elektromotoren. Weiterhin betrifft die Erfindung Verfahren zum Überwachen von Treiberschaltungen zur Ansteuerung der Elektromotoren.

### Stand der Technik

Aus der DE 420 91 67 A1 ist es bekannt, in einem Stromrichter einen Feldeffekttransistor zu überwachen, um einen Kurzschluss zu erkennen. Der Kurzschluss wird anhand eines Spannungsabfalls über dem zu überwachenden Feldeffekttransistor erkannt.

Die US 2007/035976 A1 beschreibt ein Verfahren zum Überwachen einer Versorgungs-Endstufe, bei dem mittels PWM-Pulse die Halbleiterschalter mindestens einer Halbbrücke in leitendem und nichtleitendem Zustand geprüft werden.

In der US 2009/045763 A1 ist ein Verfahren zum Überwachen einer Endstufe für einen Elektromotor offenbart, die mittels PWM-Pulse angesteuert wird. Dabei wird die Summe der Pulsbreiten der Signale über ein Zeitfenster durch einen getakteten Zähler gemessen und mit einem vorgegebenen Toleranzbereich verglichen.

Mit der US 4 369 492 A ist eine Vorrichtung zum Überwachen eines DC-AC Konverters bekannt geworden, bei der Sperr-Intervalle an Halbleiterelemente angelegt werden, die mit entsprechenden Referenz-Intervallen verglichen werden.

### Offenbarung der Erfindung

Erfindungsgemäß sind ein Verfahren zum Überwachen eines Halbbrückenzweiges in einer Halbbrücke gemäß Anspruch 1 sowie ein Verfahren zum Schützen einer Parallelschaltung aus einer ersten Halbbrücke und wenigstens einer zweiten Halbbrücke, eine Vorrichtung, ein Computerprogramm, ein elektronisches Speichermedium und ein elektrisches Steuergerät gemäß den nebengeordneten Ansprüchen 5-9 vorgesehen Bevorzugte Ausgestaltungen sind in den abhängigen Ansprüchen angegeben. Gemäß einem Aspekt der Erfindung umfasst ein Verfahren zum Überwachen eines Halbbrückenzweiges in einer Halbbrücke, der in der Halbbrücke über einen Mittelabgriff mit einem weiteren Halbbrückenzweig in Reihe verbunden ist, die Schritte:
- Anlegen eines dem Mittelabgriff gegenüberliegenden elektrischen Versorgungspotentials am weiteren Halbbrückenzweig an den Mittelabgriff mit einem vorbestimmten zeitlichen Verlaufs; und
- Überwachen des Halbbrückenzweiges basierend auf einer Gegenüberstellung des vorbestimmten Zeitverlaufs und einem elektrischen Ausgangspotenzial am Mittelabgriff.

Dem obigen Verfahren liegt die Überlegung zugrunde, dass zur eingangs genannten Überwachung des Feldeffekttransistors des Stromrichter basierend auf einem Spannungsabfall über dem Feldeffekttransistor die Erfassung von mindestens zwei Potentialen notwendig ist, um den Spannungsabfall messtechnisch zu erfassen. Zum Überwachen der Feldeffekttransistoren in einer einzigen Halbbrücke müssten daher mindestens drei verschiedene elektrische Potenzale erfasst werden. Auf einen Kurzschluss eines Feldeffekttransistors in der Halbbrücke kann erst dann geschlossen werden, wenn der Strom durch den Feldeffekttransistor so groß wird, dass der Spannungsabfall am kurzgeschlossenen Feldeffekttransistor eine vorbestimmte Spannungsschwelle überschreitet. Da jedoch insbesondere in Stromrichterschaltungen teils sehr hohe Spannungsspitzen auftreten können, muss als Spannungsschwelle nicht nur ein sehr hoher Wert berücksichtigt werden, die Spannungsschwelle muss auch zeitlich entsprechend lang ausgelegt werden, wodurch der entsprechend andere, noch nicht kurzgeschlossene Feldeffekttransistor in der Halbbrücke sehr hohen Belastungen ausgesetzt werden könnte.

Dem obigen Verfahren liegt weiter die Überlegung zugrunde, dass in einer Halbbrücke ein kurzgeschlossener Halbbrückenzweig, wie beispielsweise der eingangs genannte Feldeffekttransistor, den Mittelabgriff der Halbbrücke entweder konstant auf das vom Mittelabgriff aus gesehene hohe oder niedrige Versorgungspotenzial legen, je nachdem, welcher Halbbrückenzweig kurzgeschlossen ist. Da eine Halbbrücke andererseits in der Regel die Aufgabe übernimmt, das hohe oder das niedrige Versorgungspotenzial über einen der Halbbrückenzweige der Halbbrücke mit einem vorbestimmten Zeitverlauf an den Mittelabgriff zu legen, um beispielsweise am Mittelabgriff ein Wechselpotential als Ausgangspotential zu erzeugen, kann es als Fehlerfall identifiziert werden, wenn sich dieser vorbestimmte Zeitverlauf im Ausgangspotential am Mittelabgriff nicht beobachten lässt, weil beispielsweise der andere Halbbrückenzweig entsprechend das niedrige oder das hohe Versorgungspotenzial dauerhaft als Ausgangspotential an den Mittelabgriff anlegt. Im Rahmen des obigen Verfahrens wird diese Erkenntnis genutzt, um einen Kurzschluss eines Halbbrückenzweiges, wie einem Feldeffekttransistor in einer Halbbrücke sicher zu erkennen.

Gegenüber dem eingangs genannten Verfahren, im Rahmen dessen Spannungsabfälle über den Halbbrückenzweigen einer Halbbrücke zum Erkennen von Kurzschlüssen verwendet werden, lässt sich im Rahmen des angegebenen Verfahrens die Anzahl der benötigten, zu erfassenden Potentiale für die Überwachung der Halbbrückenzweige in jeder Halbbrücke auf ein einziges Potential und zwar das Ausgangspotential am Mittelabgriff reduzieren. Auf diese Weise wird der Schaltungsaufwand für die Überwachung der Halbbrückenzweige spürbar gesenkt. Zudem kann ein Kurzschluss eines Halbbrückenzweiges zeitnah erkannt werden, da ein Abweichen des Ausgangspotentials am Mittelabgriff vom vorbestimmten Zeitverlauf, mit dem das Versorgungspotential an den Mittelabgriff angelegt wird, nur auf einen Kurzschluss des jeweils anderen Halbbrückenzweiges in der Halbbrücke zurückgeführt werden kann. Andere Gründe, wie beispielsweise die Spannungsspitzen im eingangs genannten Verfahren können nicht vorliegen.

Somit vereinfacht das angegebene Verfahren nicht nur den Schaltungsaufbau zur Überwachung von Halbbrückenzweigen in einer Halbbrücke, mit dem Verfahren können Kurzschlüsse der Halbbrückenzweige auch schneller erkannt werden, wodurch die elektrischen Belastungen der noch funktionierenden Halbbrückenzweige spürbar gesenkt werden.

Mit dem Schritt Anlegen eines dem Mittelabgriff gegenüberliegenden elektrischen Versorgungspotentials am weiteren Halbbrückenzweig an den Mittelabgriff mit einem vorbestimmten zeitlichen Verlaufs soll der Leistungsfluss durch die Halbbrücke nicht eingeschränkt werden. Das heißt, dass ein elektrischer Strom durchaus auch vom Mittelabgriff zurück zum Versorgungspotential fließen könnte.

In einer Ausführungsform des obigen Verfahrens wird der vorbestimmte Zeitverlauf durch eine Pulsweitenmodulation vorgegeben. Insbesondere in Stromrichtern wird die Pulsweitenmodulation sehr häufig herangezogen, um aus dem Versorgungspotential an der Halbbrücke ein Wechselpotential am Mittelabgriff zu erzeugen. Alternativ könnten jedoch auch andere Modulationsarten herangezogen werden, die dem Fachmann geläufig sind, und die der Kürze halber nicht weiter erwähnt werden sollen. Entsprechend würden diese anderen Modulationsarten den vorbestimmten Zeitverlauf, mit dem das Versorgungspotential an den Mittelabgriff angelegt wird, vorgeben.

In einer zusätzlichen Ausführungsform des obigen Verfahrens wird zum Gegenüberstellen des vorbestimmten Zeitverlaufs und des Ausgangspotenzial eine Eigenschaft der Pulsweitenmodulation im Ausgangspotenzial gesucht. Dieser Ausführungsform liegt die Überlegung zugrunde, dass sich die Pulsweitenmodulation anhand bestimmter Kenngrößen, die die Pulsweitenmodulation eindeutig charakterisieren. Es muss daher nicht der gesamte zeitliche Verlauf konstant überwacht werden, es reicht aus, wenn die verwendete Pulsweitenmodulation anhand der Kenngröße eindeutig im Ausgangspotential am Mittelabgriff eindeutig erkannt wird.

Als Eigenschaft der Pulsweitenmodulation können eine oder mehrere Kenngrößen der Pulsweitenmodulation herangezogen werden. So können beispielsweise die Breiten bestimmter Pulse ausgewertet werden oder vorzugsweise eine Frequenz der Pulsweitenmodulation, die besonders bevorzugt die Modulationsfrequenz sein kann.

In einer weiteren, nicht zur Erfindung gehörigen Ausführungsform umfasst das obige Verfahren den Schritt Zählen einer Anzahl von Impulsen im Ausgangspotenzial über eine vorbestimmte Zeit, wobei zum Gegenüberstellen des vorbestimmten Zeitverlaufs und dem Ausgangspotenzial die Impulszahl mit einem Produkt aus der Frequenz der Pulsweitenmodulation und der vorbestimmten Zeit verglichen wird. Dieser Weiterbildung liegt die Überlegung zugrunde, dass das Messen von Frequenzen eines Signals mit den geringsten Messfehlern durchgeführt werden kann, so dass auf eine Beschädigung des zu überwachenden Halbbrückenzweiges zuverlässig geschlossen werden kann, wenn die Impulszahl vom Produkt aus der Frequenz der Pulsweitenmodulation und der vorbestimmten Zeit voneinander abweichen.

Gemäß einem weiteren Aspekt der Erfindung umfasst ein Verfahren zum Schützen einer Parallelschaltung aus einer ersten Halbbrücke und wenigstens einer zweiten Halbbrücke, deren Mittelabgriffe über ein elektrisches Bauelement miteinander verbunden sind die Schritte
- Überwachen der Halbbrücken mit einem der obigen Verfahren, und
- Unterbrechen aller Halbbrückenzweige, wenn die Gegenüberstellung des vorbestimmten Zeitverlaufs und des elektrischen Ausgangspotenzials eine vorbestimmte Bedingung erfüllt.

Unter diese vorbestimmte Bedingung kann dabei eine Abweichung des vorbestimmten Zeitverlaufs vom elektrischen Ausgangspotenzial fallen.

Vorzugsweise sollte beim Überwachen einer der Halbbrückenzweige in einer der Halbbrücken der vom Mittelabgriff ausgesehene Halbbrückenzweig in der anderen Halbbrücke, der dem zu überwachenden Halbbrückenzweig schräg gegenüberliegt, konstant durchgeleitet werden, damit das Ausgangspotential am Mittelabgriff nicht durch diesen schräg gegenüberliegenden Mittelabgriff verfälscht wird. In diesem Fall ist es jedoch ratsam, dass Bauelement zwischen den beiden Mittelabgriffen ein Potenzialgefälle zu erzeugt, damit das Ausgangspotential am Mittelabgriff am zu überwachenden Halbbrückenzweig nicht konstant auf eines der beiden Versorgungspotentiale gelegt wird.

Gemäß einem weiteren Aspekt der Erfindung ist ein Stromrichter zur elektrischen Energieversorgung eines Elektromotors mit einer Vorrichtung, insbesondere Recheneinheit, zum Überwachen eines Halbbrückenzweiges in einer Halbbrücke, der in der Halbbrücke über einen Mittelabgriff mit einem weiteren Halbbrückenzweig in Reihe verbunden ist, eingerichtet,
- ein dem Mittelabgriff gegenüberliegendes elektrisches Versorgungspotential am weiteren Halbbrückenzweig an den Mittelabgriff mit einem vorbestimmten zeitlichen Verlauf anzulegen; und
- den Halbbrückenzweig basierend auf einer Gegenüberstellung des vorbestimmten Zeitverlaufs und einem elektrischen Ausgangspotenzial am Mittelabgriff zu überwachen.

Die angegebene Vorrichtung ist beliebig derart weiterbar, dass es eines der angegebenen Verfahren gemäß den Unteransprüchen ausführen kann.

### Kurzbeschreibung der Zeichnungen

Bevorzugte Ausführungsformen der vorliegenden Erfindung werden nachfolgend anhand der beigefügten Zeichnungen näher erläutert. Es zeigen:
- Fig. 1: eine schematische Ansicht einer Fensterhebervorrichtung, und
- Fig. 2: eine strukturelle Ansicht eines Elektromotors der Fensterhebervorrichtung aus Fig. 1 mit einer Ansteuervorrichtung.

### Beschreibung der Ausführungsformen

In den Figuren werden gleiche Elemente mit gleichen Bezugszeichen versehen und nur einmal beschrieben.

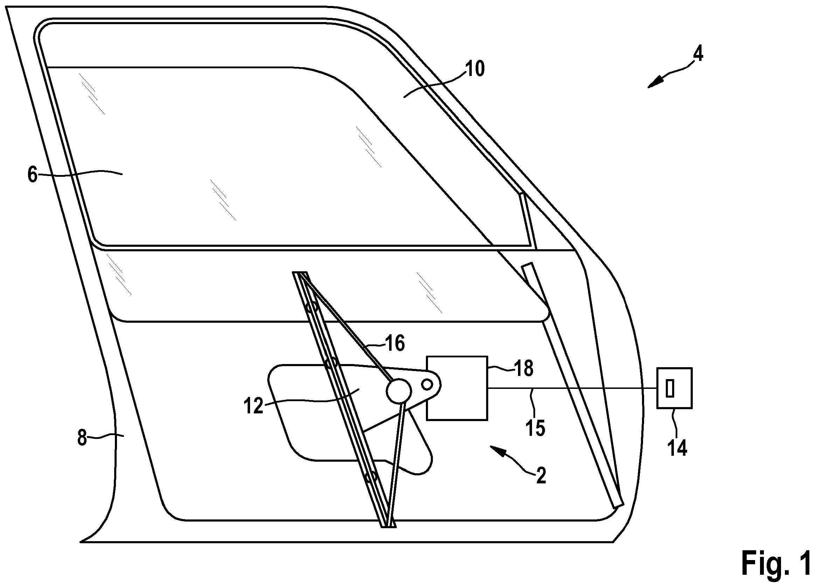

Es wird auf In Fig. 1 Bezug genommen, die eine schematische Ansicht einer Fensterhebervorrichtung 2 in einer Seitentür 4 eines nicht näher dargestellten Kraftfahrzeugs zeigt.

Die Fensterhebervorrichtung 2 ist in der vorliegenden Ausführung vorgesehen, ein bewegliches Element in Form einer Fensterscheibe 6 in einem Rahmen 8 herauf- und herunterzufahren, und so die Größe einer Fensteröffnung 10 einzustellen. Die Fensterscheibe 6 kann dabei mittels eines Elektromotors 12 bewegt werden, der über eine Bedienvorrichtung 14 mittels eines Startsignals 15 einund ausgeschaltet wird. Die Kraftübertragung vom Elektromotor 12 auf die zu bewegende Fensterscheibe 6 erfolgt dabei über einen Seilzug 16.

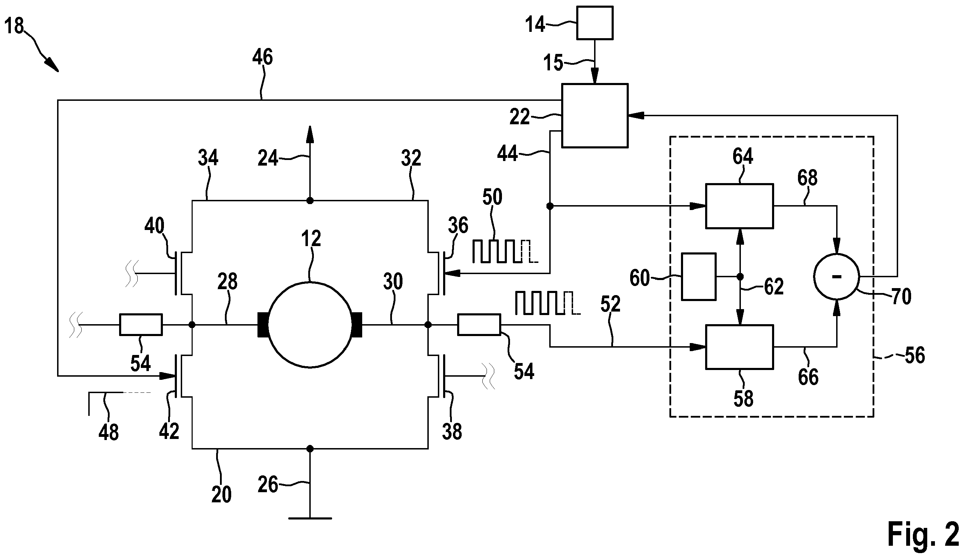

Der Elektromotor 12 wird dabei über eine Steuervorrichtung 18 angesteuert, was anhand Fig. 2 näher erläutert werden soll.

Die Steuervorrichtung 18 umfasst in der vorliegenden Ausführung einen Stromrichter 20, der angesteuert durch einen Pulsweitenmodulationseinheit 22, nachstehend PWM-Einheit 22 genannt, in einer dem Fachmann bekannten Weise eine Gleichspannung in eine Wechselspannung umwandelt. Die PWM-Einheit 22 kann dabei durch die Bedienvorrichtung 14 ein- und ausgeschaltet werden. Die Gleichspannung wird dabei zwischen einem ersten Versorgungspotential 24 und einem zweiten Versorgungspotential 26, die in der vorliegenden Ausführung entsprechend als Betriebsspannung 24 und als Masse 26 ausgebildet sind, abgegriffen. Die Wechselspannung wird zwischen den Mittelabgriffen 28, 30 zweier Halbbrücken 32, 34 abgegriffen, deren entsprechende Halbbrückenzweige als Feldeffekttransistoren 36, 38, 40, 42 ausgebildet sind, die von der PWM-Einheit 22 angesteuert werden.

Das Ausführungsbeispiel soll nachstehend anhand einer Ansteuerung des betriebsspannungsseitigen Feldeffekttransistors 36 der ersten Halbbrücke 32 und des masseseitigen Feldeffekttransistors 42 der zweiten Halbbrücke 34 durch die PWM-Einheit 22 erläutert werden. In der vorliegenden Ausführungsform gibt die PWM-Einheit 22 dazu ein erstes Steuersignal 44 an den betriebsspannungsseitigen Feldeffekttransistor 36 der ersten Halbbrücke 32 und ein zweites Steuersignal 46 an den masseseitigen Feldeffekttransistor 42 der zweiten Halbbrücke 34 aus.

Das zweite Steuersignal 44 weist eine durch die PWM-Einheit 22 vorgegebene Gleichspannungsform 48 auf, so dass der masseseitigen Feldeffekttransistor 42 der zweiten Halbbrücke 34 statisch eingeschaltet und der Elektromotor 12 über den masseseitigen Feldeffekttransistor 42 der zweiten Halbbrücke 34 dauerhaft mit dem Massepotential 26 verbunden wird.

Das erste Steuersignal 44 weist eine durch die PWM-Einheit 22 vorgegebene Wechselspannungsform 50 auf, so dass der betriebsspannungsseitige Feldeffekttransistor 36 der ersten Halbbrücke 32 in einer dem Fachmann bekannten Weise getaktet wird, um einen bestimmten Ausgangspotentialverlauf am Mittelabgriff 30 der ersten Halbbrücke 32 zu erzeugen. Damit fällt über dem Elektromotor 12 dieser bestimmte Ausgangspotentialverlauf ab und treibt den Elektromotor beispielsweise linksdrehend an. Zusätzlich kann der masseseitige Feldeffekttransistor 38 der ersten Halbbrücke 32 in nicht gezeigter Weise ebenfalls antipodal zum betriebsspannungsseitigen Feldeffekttransistor 36 der ersten Halbbrücke 32 getaktet werden, um eine intrinsische Freilaufdiode im betriebsspannungsseitigen Feldeffekttransistor 36 der ersten Halbbrücke 32 in einer dem Fachmann bekannten Weise zu überbrücken und die Verlustleistung zu senken.

Wenn jedoch der masseseitige Feldeffekttransistor 38 der ersten Halbbrücke 32 aufgrund eines Defektes kurzgeschlossen ist, so würde ein durch das durch den betriebsspannungsseitigen Feldeffekttransistor 36 der ersten Halbbrücke 32 erzeugte Ausgangspotential am Mittelabgriff 30 der ersten Halbbrücke 32 zu einem Kurzschlussstrom durch die erste Halbbrücke 32 führen, der gegebenenfalls auch den betriebsspannungsseitigen Feldeffekttransistor 36 der ersten Halbbrücke 32 beschädigen oder sogar zerstören könnte. Um dies zu vermeiden wird im Rahmen der vorliegenden Ausführung vorgeschlagen, das Ausgangspotential am Mittelabgriff 30 der ersten Halbbrücke 32 basierend auf dem ersten Steuersignal 44 zu plausibiliseren, denn das Ausgangspotential am Mittelabgriff 30 der ersten Halbbrücke 32 sollte über die Zeit gesehen die gleiche Form aufweisen, wie das erste Steuersignal 44, es sei denn, es ist durch einen fehlerhaften Kurzschluss des masseseitigen Feldeffekttransistors 38 der ersten Halbbrücke dauerhaft auf Masse 26 gelegt.

Daher wird das Ausgangspotential 52 am Mittelabgriff 30 der ersten Halbbrücke 32 über einen Schutzwiderstand 54 an eine Überwachungseinrichtung 56 geleitet, die die Impulse im Ausgangspotential 52 mit einem ersten Zähler 58 über eine aus einem Zeitgeber 60 vorgegebenen Zeitdauer 62 zählt. In gleicher Weise werden die Impulse im ersten Steuersignal 44 mit einem zweiten Zähler 64 über die Zeitdauer 62 gezählt. Nur wenn die erste Impulszahl 66 aus dem Ausgangspotential 52 über die Zeitdauer 62 gleich der zweiten Impulszahl 68 aus dem Steuersignal 44 ist, ist der masseseitige Feldeffekttransistor 38 der ersten Halbbrücke 32 kurzschlussfrei. Anderenfalls würde ein Vergleich 70 der beiden Impulszahlen 66, 68 zu Impulszahldifferenz 66, 68 führen, basierend auf der die PWM-Einheit 22 und damit der Stromrichter 20 abgeschaltet werden kann.

Wird statt dem betriebsspannungsseitigen Feldeffekttransistor 36 der ersten Halbbrücke 32 der masseseitige Feldeffekttransistor 42 der zweiten Halbbrücke 34 getaktet, so würde ein Kurzschluss im betriebsspannungsseitigen Feldeffekttransistor 40 der zweiten Halbbrücke 34 den Mittenabgriff 28 der zweiten Halbbrücke 34 dauerhaft auf das Potential der Betriebsspannung 24 legen, und ebenfalls zu einer ersten Impulszahl 66 führen, die von einer zweiten Impulszahl 68 diesmal im zweiten Steuersignal 46 verschieden wäre. Damit könnte ein Kurzschluss in jedem einzelnen Feldeffekttransistor 36, 38, 40, 42 gefunden werden, wobei in Fig. 2 die aufgebrochen dargestellten Leitungen entsprechend notwendige Steuerleitungen zur PWM-Einheit 22 und Messleitungen zur Überwachungseinrichtung 56 darstellen, die der Übersichtlichkeit halber nicht vollständig eingezeichnet sind.

Das vorliegende Ausführungsbeispiel wurde anhand eines zweiphasigen Wechselrichters als Stromrichter 20 beschrieben. Es ist jedoch in einfacher Weise auf beliebig mehrphasige Stromrichter erweiterbar.

## Patentansprüche

1. Verfahren zum Überwachen eines Halbbrückenzweiges (38) in einer Halbbrücke (32), der in der Halbbrücke (32) über einen Mittelabgriff (30) mit einem weiteren Halbbrückenzweig (36) in Reihe verbunden ist, umfassend:
- Getaktetes Anlegen eines am weiteren Halbbrückenzweig (36) dem Mittelabgriff (30) gegenüberliegenden elektrischen Versorgungspotentials (24) an den Mittelabgriff (30) mit einem vorbestimmten Zeitverlauf (50), wobei eine PWM-Einheit (22) ein erstes Steuersignal (44) mit dem vorbestimmten Zeitverlauf (50) an den weiteren Halbbrückenzweig (36) der ersten Halbbrücke (32) ausgibt;
- Überwachen des Halbbrückenzweiges (38) basierend auf einer Gegenüberstellung (70) des vorbestimmten Zeitverlaufs (50) und einem elektrischen Ausgangspotenzial (52) am Mittelabgriff (30),**dadurch gekennzeichnet, dass** die PWM-Einheit (22) ein zweites Steuersignal (46) an einen masseseitigen Feldeffekttransistor (42) einer zweiten Halbbrücke (34) ausgibt, wobei das zweite Steuersignal (46) eine durch die PWM-Einheit (22) vorgegebene Gleichspannungsform (48) aufweist, so dass der masseseitige Feldeffekttransistor (42) der zweiten Halbbrücke (34) statisch eingeschaltet und ein Elektromotor (12) über den masseseitigen Feldeffekttransistor (42) der zweiten Halbbrücke (34) dauerhaft mit einem Massepotential (26) verbunden ist,
und eine Überwachungseinrichtung (56) Impulse im Ausgangspotenzial (52) mit einem ersten Zähler (58) über eine aus einem Zeitgeber (60) vorgegebene Zeitdauer (62) zählt und in gleicher Weise Impulse im ersten Steuersignal (44) mit einem zweiten Zähler (64) über die Zeitdauer (62) zählt, wobei die Gegenüberstellung (70) nach der vorgegebenen Zeitdauer (62) durch das Vergleichen der Zähler (58, 64) erfolgt, derart, dass wenn eine erste Impulszahl (66) des ersten Zählers (58) gleich einer zweiten Impulszahl (68) ist, der masseseitige Feldeffekttransistor (38) der ersten Halbbrücke (32) kurzschlussfrei ist.

2. Verfahren nach Anspruch 1, wobei der vorbestimmte Zeitverlauf (50) durch eine Pulsweitenmodulation vorgegeben wird.

3. Verfahren nach Anspruch 2, wobei zum Gegenüberstellen (70) des vorbestimmten Zeitverlaufs (50) und des Ausgangspotenzial (52) eine Eigenschaft der Pulsweitenmodulation im Ausgangspotenzial (52) gesucht wird.

4. Verfahren nach Anspruch 3, wobei die Eigenschaft der Pulsweitenmodulation eine Frequenz der Pulsweitenmodulation ist.

5. Verfahren zum Schützen einer Parallelschaltung (20) aus einer ersten Halbbrücke (32) und wenigstens einer zweiten Halbbrücke (34), deren Mittelabgriffe (28, 30) über ein elektrisches Bauelement (12) miteinander verbunden sind, umfassend
- Überwachen der Halbbrücken (32, 34) mit einem Verfahren nach einem der vorangehenden Ansprüche, und
- Unterbrechen aller Halbbrückenzweige (36, 38, 40, 42), wenn die Gegenüberstellung des vorbestimmten Zeitverlaufs (50) und des elektrischen Ausgangspotenzials (52) eine vorbestimmte Bedingung erfüllt.

6. Stromrichter (20) zur elektrischen Energieversorgung eines Elektromotors (12) umfassend
- eine Parallelschaltung aus einer ersten Halbbrücke (32) und wenigstens einer zweiten Halbbrücke (34), deren Mittelabgriffe (28, 30) über den Elektromotor (12) miteinander verbindbar sind, und
- eine Vorrichtung (56), insbesondere Recheneinheit, zum Überwachen eines Halbbrückenzweiges (38) in der ersten Halbbrücke (32), der in der ersten Halbbrücke (32) über einen Mittelabgriff (30) mit einem weiteren Halbbrückenzweig (36) in Reihe verbunden ist, **dadurch gekennzeichnet, dass** eine PWM-Einheit (22) ein erstes Steuersignal (44) an den weiteren Halbbrückenzweig (36) der ersten Halbbrücke (32) ausgibt, und die Vorrichtung (56) eingerichtet ist,
- ein dem Mittelabgriff (30) gegenüberliegendes elektrisches Versorgungspotential (24) am weiteren Halbbrückenzweig (36) an den Mittelabgriff (30) mit einem vorbestimmten Zeitverlauf (50) getaktet anzulegen; wobei die PWM-Einheit (22) ein zweites Steuersignal (46) an einen masseseitigen Feldeffekttransistor (42) des zweiten Halbbrücke (34) ausgibt, wobei das zweite Steuersignal (46) eine durch die PWM-Einheit (22) vorgegebene Gleichspannungsform (48) aufweist, so dass der masseseitigen Feldeffekttransistor (42) der zweiten Halbbrücke (34) statisch eingeschaltet und der Elektromotor (12) über den masseseitigen Feldeffekttransistor (42) der zweiten Halbbrücke (34) dauerhaft mit einem Massepotential (26) verbunden ist,
- den Halbbrückenzweig (38) basierend auf einer Gegenüberstellung (70) des vorbestimmten Zeitverlaufs (50) und einem elektrischen Ausgangspotenzial (52) am Mittelabgriff (30) zu überwachen; und
- Impulse im Ausgangspotenzial (52) mit einem ersten Zähler (58) über eine aus einem Zeitgeber (60) vorgegebene Zeitdauer (62) zu zählen und in gleicher Weise Impulse im ersten Steuersignal (44) mit einem zweiten Zähler (64) über die Zeitdauer (62) zu zählen, wobei die Gegenüberstellung (70) nach der vorgegebenen Zeitdauer (62) durch das Vergleichen der Zähler (58, 64) erfolgt, derart, dass wenn eine erste Impulszahl (66) des ersten Zählers (58) gleich einer zweiten Impulszahl (68) ist, der masseseitige Feldeffekttransistor (38) der ersten Halbbrücke (32) kurzschlussfrei ist.

7. Computerprogramm umfassend Befehle, die bewirken, dass die Vorrichtung des Anspruchs 6 die Verfahrensschritte nach einem der Ansprüche 1 bis 5 ausführt.

8. Elektronisches Speichermedium, auf welchem ein Computerprogramm nach Anspruch 7 gespeichert ist

9. Elektronische Steuergerät, welches ein elektronisches Speichermedium nach Anspruch 8 aufweist.

## Claims

1. Method for monitoring a half-bridge branch (38) in a half-bridge (32), which half-bridge branch is connected in series with a further half-bridge branch (36) via a centre tap (30) in the half-bridge (32), comprising:
- applying an electric supply potential (24), opposite the centre tap (30) on the further half-bridge branch (36), to the centre tap (30) with a predetermined temporal profile (50) in a clocked manner, wherein a PWM unit (22) outputs a first control signal (44) with the predetermined temporal profile (50) to the further half-bridge branch (36) of the first half-bridge (32);
- monitoring the half-bridge branch (38) based on a comparison (70) of the predetermined temporal profile (50) with an electric output potential (52) at the centre tap (30), **characterized in that** the PWM unit (22) outputs a second control signal (46) to an earth-side field-effect transistor (42) of a second half-bridge (34), wherein the second control signal (46) has a DC voltage form (48) predefined by the PWM unit (22), with the result that the earth-side field-effect transistor (42) of the second half-bridge (34) is switched on in a static manner and an electric motor (12) is permanently connected to an earth potential (26) via the earth-side field-effect transistor (42) of the second half-bridge (34), and a monitoring device (56) counts pulses in the output potential (52) with a first counter (58) over a time period (62) predefined by a timer (60) and counts pulses in the first control signal (44) with a second counter (64) over the time period (62) in the same way, wherein the comparison (70) is carried out after the predefined time period (62) by comparing the counters (58, 64) in such a way that if a first pulse number (66) of the first counter (58) is equal to a second pulse number (68), the earth-side field-effect transistor (38) of the first half-bridge (32) is free from short circuits.

2. Method according to Claim 1, wherein the predetermined temporal profile (50) is predefined by a pulse width modulation.

3. Method according to Claim 2, wherein a property of the pulse width modulation in the output potential (52) is sought to compare (70) the predetermined temporal profile (50) with the output potential (52).

4. Method according to Claim 3, wherein the property of the pulse width modulation is a frequency of the pulse width modulation.

5. Method for protecting a parallel circuit (20) comprising a first half-bridge (32) and at least one second half-bridge (34), the centre taps (28, 30) of which are connected to one another via an electrical component (12), comprising:
- monitoring the half-bridges (32, 34) using a method according to one of the preceding claims, and
- interrupting all the half-bridge branches (36, 38, 40, 42) if the comparison of the predetermined temporal profile (50) with the electric output potential (52) meets a predetermined condition.

6. Power converter (20) for supplying electrical energy to an electric motor (12), comprising:
- a parallel circuit comprising a first half-bridge (32) and at least one second half-bridge (34), the centre taps (28, 30) of which can be connected to one another via the electric motor (12), and
- an apparatus (56), in particular computing unit, for monitoring a half-bridge branch (38) in the first half-bridge (32), which half-bridge branch is connected in series with a further half-bridge branch (36) via a centre tap (30) in the first half-bridge (32), **characterized in that** a PWM unit (22) outputs a first control signal (44) to the further half-bridge branch (36) of the first half-bridge (32), and the apparatus (56) is designed
- to apply an electric supply potential (24), opposite the centre tap (30) on the further half-bridge branch (36), to the centre tap (30) with a predetermined temporal profile (50) in a clocked manner, wherein the PWM unit (22) outputs a second control signal (46) to an earth-side field-effect transistor (42) of the second half-bridge (34), wherein the second control signal (46) has a DC voltage form (48) predefined by the PWM unit (22), with the result that the earth-side field-effect transistor (42) of the second half-bridge (34) is switched on in a static manner and the electric motor (12) is permanently connected to an earth potential (26) via the earth-side field-effect transistor (42) of the second half-bridge (34),
- to monitor the half-bridge branch (38) based on a comparison (70) of the predetermined temporal profile (50) with an electric output potential (52) at the centre tap (30), and
- to count pulses in the output potential (52) with a first counter (58) over a time period (62) predefined by a timer (60) and to count pulses in the first control signal (44) with a second counter (64) over the time period (62) in the same way, wherein the comparison (70) is carried out after the predefined time period (62) by comparing the counters (58, 64) in such a way that if a first pulse number (66) of the first counter (58) is equal to a second pulse number (68), the earth-side field-effect transistor (38) of the first half-bridge (32) is free from short circuits.

7. Computer program comprising instructions that cause the apparatus of Claim 6 to carry out the method steps according to one of Claims 1 to 5.

8. Electronic storage medium, on which a computer program according to Claim 7 is stored.

9. Electronic control device, which has an electronic storage medium according to Claim 8.

## Revendications

1. Procédé permettant de surveiller une branche de demi-pont (38) dans un demi-pont (32) qui est connectée en série avec une autre branche de demi-pont (36) dans le demi-pont (32) par l'intermédiaire d'une prise médiane (30), comprenant les étapes consistant à :
- appliquer à la prise médiane (30) de manière cadencée, avec une courbe de temps prédéterminée (50), un potentiel d'alimentation électrique (24) opposé à la prise médiane (30) sur l'autre branche de demi-pont (36), dans lequel une unité PWM (22) émet un premier signal de commande (44) avec la courbe de temps prédéterminée (50) à l'autre branche de demi-pont (36) du premier demi-pont (32) ;
- surveiller la branche de demi-pont (38) sur la base d'une juxtaposition (70) de la courbe de temps prédéterminée (50) et d'un potentiel de sortie électrique (52) au niveau de la prise médiane (30),
**caractérisé en ce que** l'unité PWM (22) émet un deuxième signal de commande (46) à un transistor à effet de champ côté masse (42) d'un deuxième demi-pont (34), le deuxième signal de commande (46) présentant une forme de tension continue (48) prédéfinie par l'unité PWM (22) de sorte que le transistor à effet de champ côté masse (42) du deuxième demi-pont (34) est mis en circuit de manière statique, et un moteur électrique (12) est relié durablement au potentiel de masse (26) par l'intermédiaire du transistor à effet de champ côté masse (42) du deuxième demi-pont (34),
et un dispositif de surveillance (56) compte des impulsions dans le potentiel de sortie (52) à l'aide d'un premier compteur (58) pendant une période (62) prédéfinie par un temporisateur (60) et compte de la même manière des impulsions dans le premier signal de commande (44) à l'aide d'un deuxième compteur (64) pendant la période (62), la juxtaposition (70) ayant lieu à l'issue de la période prédéfinie (62) par la comparaison des compteurs (58, 64) de telle sorte que si un premier nombre d'impulsions (66) du premier compteur (58) est égal à un deuxième nombre d'impulsions (68), le transistor à effet de champ côté masse (38) du demi-pont (32) est exempt de courtcircuit.

2. Procédé selon la revendication 1, dans lequel la courbe de temps prédéterminée (50) est prédéfinie par une modulation d'impulsions en largeur.

3. Procédé selon la revendication 2, dans lequel une propriété de la modulation d'impulsions en largeur est cherchée dans le potentiel de sortie (52) pour juxtaposer (70) la courbe de temps prédéterminée (50) et le potentiel de sortie (52).

4. Procédé selon la revendication 3, dans lequel la propriété de la modulation d'impulsions en largeur est une fréquence de la modulation d'impulsions en largeur.

5. Procédé permettant de protéger un montage en parallèle (20) composé d'un premier demi-pont (32) et d'au moins un deuxième demi-pont (34) dont les prises médianes (28, 30) sont reliées l'une à l'autre par l'intermédiaire d'un composant électrique (12), comprenant les étapes consistant à
- surveiller les demi-ponts (32, 34) par un procédé selon l'une quelconque des revendications précédentes, et
- couper toutes les branches de demi-pont (36, 38, 40, 42) si la juxtaposition de la courbe de temps prédéterminée (50) et du potentiel électrique de sortie (52) remplit une condition prédéterminée.

6. Convertisseur de courant (20) permettant d'alimenter un moteur électrique (12) en énergie électrique, comprenant
- un montage en parallèle composé d'un premier demi-pont (32) et d'au moins un deuxième demi-pont (34) dont les prises médianes (28, 30) peuvent être reliées l'une à l'autre par l'intermédiaire du moteur électrique (12), et
- un dispositif (56), en particulier une unité de calcul, permettant de surveiller une branche de demi-pont (38) dans le premier demi-pont (32) qui est reliée en série dans le premier demi-pont (32) par l'intermédiaire d'une prise médiane (30) à une autre branche de demi-pont (36),
**caractérisé en ce qu'**une unité PWM (22) émet un premier signal de commande (44) à l'autre branche de demi-pont (36) du premier demi-pont (32), et le dispositif (56) est conçu pour
- appliquer à la prise médiane (30) de manière cadencée, avec une courbe de temps prédéterminée (50), un potentiel d'alimentation électrique (24) opposé à la prise médiane (30) sur l'autre branche de demi-pont (36) ; l'unité PWM (22) émettant un deuxième signal de commande (46) à un transistor à effet de champ côté masse (42) du deuxième demi-pont (34), le deuxième signal de commande (46) présentant une forme de tension continue (48) prédéfinie par l'unité PWM (22) de sorte que le transistor à effet de champ côté masse (42) du deuxième demi-pont (34) est mis en circuit de manière statique, et le moteur électrique (12) est relié durablement au potentiel de masse (26) par l'intermédiaire du transistor à effet de champ côté masse (42) du deuxième demi-pont (34),
- surveiller la branche de demi-pont (38) sur la base d'une juxtaposition (70) de la courbe de temps prédéterminée (50) et d'un potentiel électrique potentiel de sortie (52) au niveau de la prise médiane (30) ; et
- compter des impulsions dans le potentiel de sortie (52) à l'aide d'un premier compteur (58) pendant une période (62) spécifiée par un temporisateur (60) et pour compter de la même manière des impulsions dans le premier signal de commande (44) à l'aide d'un deuxième compteur (64) pendant la période (62), la juxtaposition (70) ayant lieu à l'issue de la période prédéfinie (62) par la comparaison des compteurs (58, 64) de telle sorte que si un premier nombre d'impulsions (66) du premier compteur (58) est égal à un deuxième nombre d'impulsions (68), le transistor à effet de champ côté masse (38) du demi-pont (32) est exempt de courtcircuit.

7. Programme informatique comprenant des instructions qui font que le dispositif selon la revendication 6 exécute les étapes de procédé selon l'une quelconque des revendications 1 à 5.

8. Support de stockage électronique sur lequel est stocké un programme informatique selon la revendication 7.

9. Appareil de commande électronique qui présente un support de stockage électronique selon la revendication 8.
